(19) Europäisches Patentamt / European Patent Office / Office européen des brevets

(11) **EP 2 144 374 A1**

(12) **DEMANDE DE BREVET EUROPEEN**

(43) Date de publication:
**13.01.2010 Bulletin 2010/02**

(51) Int Cl.:
**H03M 7/30** *(2006.01)*

(21) Numéro de dépôt: **08290673.6**

(22) Date de dépôt: **08.07.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(71) Demandeur: **Trémolet, Yves**
**75009 Paris (FR)**

(72) Inventeur: **Trémolet, Yves**
**75009 Paris (FR)**

(54) **Procédés d'écriture lecture et stockage d'identifiants à nombre de segments et tailles de segments variables sur un mot de taille fixé**

(57) Principes et algorithmes de codage d'identifiants à nombre de segments et tailles de segments variables sur un mot de taille fixe.

L'objectif des principes et algorithmes présentés est de permettre de représenter tout identifiant ayant la forme $n_1, n_2 ..... n_1$, sous la forme d'une chaîne de bits ou d'octets de taille fixe. Les $n_i$ sont considérés comme des entiers, pouvant apparaître comme tels dans l'identifiant de départ, ou à travers des règles de transformation et codage de chaînes alphanumériques.

Le domaine d'application est très large, il correspond à tous les contextes où les identifiants utilisés sont des listes d'entiers (ou de numéros alphanumériques), comme par exemple dans le domaine des codes barres ou codes GS1, numérotation des livres avec la numérotation ISBN, de revues avec les ISSN, et tous les identifiants de numéros de commandes, de clients, de contrats, de comptes bancaires, de normes, de symboles, de documents, de fichiers, de codes produits, de pays, et autres instances de divers types utilisés par divers organismes publiques ou privés, nationaux ou internationaux.

L'utilisation de ces principes, par rapport aux méthodes actuelles utilisées, permettrait de se passer des tailles de segments prédéfinis (comme par exemple dans le contexte des codes GS1), ou de la maintenance de « plages » sur les premiers caractères d'un segment, définissant comment il doit être séparé en deux (comme par exemple dans le contexte de la numérotation ISBN). Ceci simplifierait grandement la distribution, l'utilisation, et la gestion associée de ces identifiants.

Les techniques utilisées pour définir ces codages et algorithmes, sont basées sur une numérotation de toutes les structures possibles de l'identifiant de départ, ce qui permet ensuite de représenter l'identifiant comme la concaténation du numéro de structure optimale pour cet identifiant, et de la liste de ses segments. Inversement, à partir d'un mot de taille fixe, on reconstruira la structure à partir du numéro de structure, et on utilisera cette structure comme « masque » pour extraire chaque segment de la chaîne ou mot de taille fixe.

EP 2 144 374 A1

**Description**

La présente invention concerne des procédés d'écriture, stockage et lecture de données ou identifiants à segments multiples, le nombre et la taille de ces segments étant fixes ou variables, sous forme d'enregistrements de taille fixe sur disques durs, enregistrements de base de données, puces RFID, ou impressions de type codes barres, ceci sans contrainte sur le nombre et la taille de chaque segment, la seule contrainte portant sur la somme des tailles des segments ainsi qu'un nombre maximal de segments, à travers l'utilisation d'algorithmes de codage et décodage utilisant une numérotation de toutes les structures de segments possible des identifiants.

Le domaine d'application correspond à tous les contextes où les identifiants utilisés sont des listes d'entiers (ou de numéros alphanumériques), comme par exemple dans le domaine des codes barres ou codes GS1, numérotation des livres avec la numérotation ISBN, des revues avec les ISSN, et tous les identifiants de numéros de commandes, de clients, de contrats, de comptes bancaires, de normes, documents, de codes produits, de routes ou pays, utilisés par divers organismes publiques ou privés, nationaux ou internationaux. Ces procédés peuvent également, comme pour les autres, être appliqués à des identifiants informatiques, par exemple pour mettre en place un système de fichier à inodes purement administratifs, ou pour tout autre objet ou symboles informatiques et codes associés.

On peut décrire le domaine de manière générale comme étant celui ou les identifiants utilisés ont la forme $n_1.n_2.....n_P$. les $n_i$ étant des entiers (ou numéros) pouvant éventuellement utiliser des lettres dans leurs représentations, c'est-à-dire de codes formés par une liste de p segments, p étant variable ou pas, et où ces identifiants doivent dans certains contextes techniques être enregistrés sur une taille fixe.

Les méthodes actuelles utilisées dans ce domaine pour écrire ces identifiants dans un mot de taille fixe reposent en général :

- Soit sur l'utilisation de tailles fixes pour délimiter les segments, comme dans le contexte des codes GS1 (ex EAN et UCC), voir par exemple page 6 section 1 du document « GS1 General Specifications v.7.0 » disponible à travers le lien ci dessous :

    http://www.gsluk.org/EANUCC/WORD_Files/GS_Secdon_1_V7.doc

- Soit sur l'utilisation de règles, et maintenance associée de « plages », définissant comment séparer un segment en deux à partir des premiers caractères, voir par exemple les documents ci-dessous dans le domaine de l'ISBN :

    http://www.isbn.org/standards/home/isbn/international/html/usm4.htm
    http://www.isbn-international.org/converter/ranges.htm

Des identifiants de la forme indiquée sont aussi bien sûr souvent utilisés sans contrainte de taille sur leurs écritures, ceci à l'aide d'une séparation syntaxique des différents segments par des caractères « . » , « / », ou autre. Cela est tout à fait approprié dans de nombreux cas, et ne pose absolument aucun problème. Cependant la contrainte de taille fixe existe aussi souvent, pour une forte automatisation du traitement de ces identifiants, ou pour des contraintes d'implémentations ou de traitements informatiques et/ou réseaux. Les procédés d'écriture décrits pourraient donc aussi être utilisés sur ces espaces d'identifiants quand les contraintes de taille existent.

La mise en oeuvre de ces procédés permettrait certainement une meilleure dynamique ou « percolation » de ces identifiants, ainsi qu'une gestion grandement simplifiée de leurs distributions, permettant en retour une utilisation plus extensive, et donc une plus grande cohérence et évolutivité des systèmes les utilisant.

**1) Description détaillée**

L'énoncé du problème est donc le suivant : on considère un espace d'identifiants de la forme $n_1.n_2.....n_j$, à $ms$ ou moins segments ($j \geq 1$ et $\leq ms$) que l'on veut représenter dans un « mot machine » de $p$ bits, ou $p$ octets. Les segments $n_k$ sont considérés comme des entiers, qu'ils apparaissent comme tels dans le code considéré ou à travers des règles de transformation/représentation. Nous considérerons dorénavant que l'espace de représentation cible est basé sur des octets, mais les principes et algorithmes énoncés peuvent s'appliquer à l'identique sur des bits, voir la partie « Applications industrielles» pour plus de détails à ce sujet.

Il s'agit donc de définir, pour des identifiants de type $n_1.n_2.... n_j$, , des fonctions *Cod* et *Decod* prenant respectivement, un identifiant et le transformant en un mot machine, un mot machine et le transformant en un identifiant, et telles que la composition de *Decod* et *Cod* soit égale à l'identité sur l'espace d'identifiants de départ. Ce que l'on peut

$$Cod_{(ms,p)} : \mathbb{N} \cup \mathbb{N}^2 \cup ... \cup \mathbb{N}^{ms} \to \left( \{0,1\}^8 \right)^p$$

$$(n_1, n_2, ..., n_j) \mapsto S \in \left( \{0,1\}' \right)^p$$

$$Decod_{(ms,p)} : \left( \{0,1\}^8 \right)^p \to \mathbb{N} \cup \mathbb{N}^2 \cup ... \cup \mathbb{N}^{ms} \cup \varnothing$$

$$S \in \left( \{0,1\}' \right)^p \mapsto (n_1, n_2, ..., n_j) \vee \varnothing$$

noter de la manière suivante :

$$Decod_{(ms,p)} \circ Cod_{(ms,p)} = Id_{\mathbb{N} \cup \mathbb{N}^2 \cup ... \cup \mathbb{N}^{ms}}$$

Le principe de base est de permettre à chaque segment d'avoir une taille variable dans la chaîne cible. Nous appellerons ici une liste de tailles de segments dans la chaîne cible une « structure ».

Une structure est donc une liste de la forme $(t_1, t_2, ..., t_j)$ avec $j \le ms$. L'idée est de numéroter toutes les structures possibles pour un couple (*ms,p*) donné. Ceci permet de définir la fonction *Cod* comme étant la fonction qui à une liste $(n_1.n_2...n_j)$, va d'abord déterminer la structure optimale pour les $n_j$, va ensuite calculer le numéro de structure correspondant, et enfin bâtir la chaîne S par concaténation de ce numéro de structure et des représentations binaires ou hexadécimales des $n_j$.

Pour la fonction *Decod*, on déduira d'abord de S la structure utilisée à partir du numéro de structure, puis on utilisera cette structure comme « masque » pour déterminer la liste $(n_1.n_2.....n_j)$ correspondante.

Le problème se ramène donc à définir, pour un couple (*ms,p*) donné, des fonctions *NStruct* et *DNStruct* ayant

$$\mathbb{N}^{(ms)} = \varnothing \cup \mathbb{N} \cup \mathbb{N}^2 \cup ... \cup \mathbb{N}^{ms}$$

la forme suivante. Nous utilisons ici pour simplifier la notation :

$$NStruct_{(ms,p)} : \mathbb{N}^{(ms)} \to \mathbb{N}$$

$$(t_1, t_2, ..., t_j), j \le ms \mapsto nstruct$$

$$(), ou \ \varnothing \mapsto 0 \qquad\qquad Et$$

$$DNStruct_{(ms,p)} : \mathbb{N} \to \mathbb{N}^{(ms)}$$

$$nstruct \mapsto (t_1, t_2, ..., t_j)$$

$$0 \mapsto ()$$

telles que : $DNStruct_{(ms,p)} \circ NStruct_{(ms,p)} = Id_{\mathbb{N}^{(ms)}}$

La fonction *NStruct* prend une liste de tailles de segments et retourne un numéro de structure, la fonction *DNStruct* retourne une liste de taille de segments à partir d'un numéro de structure. L'ensemble vide ou liste vide est aussi considéré, avec comme numéro de structure 0 pour des raisons de régularité des algorithmes. La composition de ces fonctions doit être égale à l'identité.

Méthode 1 :

Dans cette solution, on considère toutes les structures possibles, y compris celles qui ne « remplissent » pas tous les octets. Cependant, on « gaspille » les octets d'un côté et on « tasse » les identifiants de l'autre, c'est-à-dire que l'on compte par exemple une seule structure à 1 segment de 1 octet dans 3 octets.

Commençons par calculer le nombre total de structures à exactement *ms* segments noté ici *Sms*(p) pour un couple (ms,p) donné, nous avons :

S0(p) = 1 : le nombre de structure « vide » dans p octets est 1, ceci pour régularité des algorithmes

S1(p)=1 : il y a une seule structure à 1 segment dans p octets

S2(p)=p-1 : il y a p-1 structures à 2 segments dans p octets, la limite entre les deux segments pouvant aller d'après le premier octet, jusqu'à avant le dernier octet.

...

Par récurrence on a :

$$S_J(p) = \sum_{i=J-1}^{p-1} S_{J-1}(i)$$

C'est-à-dire, le nombre de structures possible à J segments dans p octets est la somme du nombre de structures possibles à J-1 segments, sur un nombre d'octets variant de p-1 à J-1, la place disponible pour le premier segment variant entre 1 et p-(J-1).

A la main, ou à l'aide d'outils de calcul symbolique, cela donne :

$$S_3(p) = \frac{1}{2}(p-1)(p-2)$$

$$S_4(p) = \frac{1}{6}(p-1)(p-2)(p-3)$$

$$S_5(p) = \frac{1}{24}(p-1)(p-2)(p-3)(p-4)$$

$$S_6(p) = \frac{1}{120}(p-1)(p-2)(p-3)(p-4)(p-5)$$

$$S_7(p) = \frac{1}{720}(p-1)(p-2)(p-3)(p-4)(p-5)(p-6)$$

$$S_8(p) = \frac{1}{5040}(p-1)(p-2)(p-3)(p-4)(p-5)(p-6)(p-7)$$

Note : Il n'y a pas lieu ici de faire croître *ms* « énormément », en effet le but est de gérer et manipuler des espaces d'identifiants de type $n_1.n_2.....n_j$ , mais pas des formes syntaxiques ou s-expressions dont les $n_i$ constitueraient les termes. Autrement dit le nombre de segments doit répondre aux contraintes administratives de distribution, mais pas de classification ou détermination d'objets à travers des phrases ou expressions syntaxiques. Ce qui ne veut pas dire bien sûr que l'on ne puisse pas bâtir après des s-expressions ou formes syntaxique à l'aide de ces identifiants, ni que ces listes aient ou prennent souvent dans la pratique une certaine syntaxe. Que le nombre de segments soit fixe ou variable, le moins possible est toujours préférable, un seul suffirait en principe, le choix du nombre de segments et de la variabilité ou pas est bien sûr du ressort des organisations gérant/utilisant ces identifiants. Dans la suite nous nous limitons à 7 au maximum, 5 suffiraient peut-être, les principes et algorithmes restant valable pour tout *ms.* Plus à ce sujet dans la partie « Applications industrielle».

Ensuite, pour calculer le nombre total de structures à *ms* ou moins segments, noté $TS_{ms}(p)$, on a :

$$TS_{ms}(p) = \sum_{i=0}^{ms} S_i(p)$$

Les représentations polynomiales des TS ne sont pas ici données, mais peuvent être « aisément » acquises. Les fonctions TS peuvent aussi être facilement calculées par récurrence de manière programmatique.

Principe de numérotation des structures, définitions de *NStruct* et *DNStruct*

Il faut maintenant définir un algorithme permettant d'expliciter un couple de fonctions *NStruct* et *DNStruct*. Pour cela, le principe est de ranger les structures de la manière suivante :

*[taille premier segment 0][taille premier segment 1]... [taille premier segment p - cs]*

Où *cs* est le nombre d'octets (ou de bits) nécessaires au codage du numéro de structure, ceci est explicité plus en détails dans la partie « Applications industrielle», pour simplifier on utilise dans la suite *p* pour noter *p-cs*
Puis, à l'intérieur de l'intervalle *[taille premier segment 1]* , on range les structures selon :

*[taille deuxième segment 0][taille deuxième segment 1]...[taille deuxième segment p-1]*

A l'intérieur de l'intervalle *[taille deuxième segment 1]* ci-dessus, on rangera les structures selon :

*[taille troisième segment 0][taille troisième segment 1]... [taille troisième segment p-3]*

Et ainsi de suite.
Ceci permet de définir un couple de fonctions *NStrusct* et *DNStruct*

Algorithme pour la fonction *NStruct :*

La fonction *NStruct* prend donc en entrée une liste de tailles de segments. Pour lui affecter un numéro, appelé ici *Idstr* pour identifiant de structure, le processus est :

1. Se positionner sur le bon intervalle correspondant à la taille du premier segment, en incrémentant au passage *Idstr* des valeurs correspondantes aux intervalles pour lesquels le premier segment à une taille inférieure à sa taille en entrée. Pour cela on utilise le fait que, pour une taille de premier segment *l*, le nombre de structures ayant *l* comme taille de premier segment sur *p* octets et *ns* segments, est égal au nombre total de structures sur *p-l* octets et *ns-1* segments.
2. Appel récursif à la fonction *NStruct* sur la structure moins le premier élément, avec les paramètres positionnés comme il faut
3. Le numéro est *Idstr* à la fin du processus

Algorithme pour la fonction *DNStruct :*

Ici on part d'un numéro *Idstr* et l'on doit retourner une liste de tailles de segments, le processus est :

1. Se positionner sur le bon intervalle en utilisant l'égalité décrite au point 1 ci-dessus
2. Ajouter la taille du segment courant en fin de structure (dans la liste)
3. Appel récursif à *DNStruct* à l' « intérieur » de l'intervalle en ayant décrémenter Idstr des valeurs correspondants aux intervalles précédents
4. la liste de tailles de segments est la structure en fin de processus

Pour expliciter ces algorithmes complètement, les tester, et aussi déterminer les valeurs de *cs* par rapport à *ms* et *p*, ces algorithmes ainsi que les fonctions définies plus haut sont exprimés à travers le programme en langage de programmation Python joint en annexe.
En particulier on a les correspondances suivantes :

- fonction $S_i(p)$ ci-dessus : fonction Structs (i,p) du programme
- fonction $TS_{mp}(p)$ ci-dessus : fonction STs (i,p) du programme
- fonction $NStruct_{(ms,p)}$ ci-dessus : fonction AlgCodage (ls, MS,P) du programme
- fonction $DNStruct_{(ms,p)}$ ci-dessus : fonction AlgDecodage (ls, MS,P) du programme
- fonction $Cod_{(7,14)}$ ci-dessus : fonction CodeListInt (lint) du programme
- fonction $Decod_{(7,14)}$ ci-dessus : fonction DecodeListInt (intg) du programme

Méthode 2 :

Ici on ne considère que les structures qui utilisent tous les octets. Cela implique, pour avoir la composition de *Decod* et *Cod* égale à l'identité, d'ajouter une règle du type : le dernier entier prend toute la place qui reste dans la fonction *Cod*. D'autres règles, telles que les bits ou octets non nécessaires sont affectés au premier entier peuvent être utilisées. Ainsi la fonction *Cod* est bien une fonction ou application, et n'associe qu'une structure possible à une liste d'entiers donnée.

Nous nous limiterons ici au calcul de la fonction déterminant le nombre total de structures pour comparaison avec la première solution, le principe des algorithmes reste le même pour les fonctions *NStruct* et *DNStruct* avec des modifications mineures.

Si on appelle $D_{ms}(p)$ le nombre de distributions (comme structures dans la méthode 1) utilisant tous les p octets pour un nombre de segments ms, on a :

$D_0(p)$ : fonction non nécessaire dans ce cas
$D_1(p)=1$ : une distribution à 1 segment sur p octets
$D_2(p)=p-1$ : même règle que pour S

Par récurrence on a:

$$D_J(p) = \sum_{i=1}^{p-J+1} D_{J-1}(p-i)$$

En effet le nombre de distributions à J segments sur p octets est égal à la somme du nombre de distributions à J-1 segments, ceci pour un nombre d'octets variant entre p-1 et J-1 (le premier segment vaut 1 d'un côté, chaque autre segment vaut 1 de l'autre).

Et:

$$TD_J(p) = \sum_{i=1}^{J} D_i(p)$$

Pour les fonctions de nombre total de distributions à J ou moins segments sur p octets.

Pour comparaison les fonction TD5(p) et TD7(p) sont exprimées de manière programmatique dans le programme Python joint en annexe avec les références :

- TD5(p) : fonction TD5 (p) du programme
- TD7(p) : fonction TD7 (p) du programme

Méthode 3 : Cas des espaces d'identifiants à nombre de segments fixe :

Les mêmes principes et algorithmes peuvent être utilisés, en utilisant les fonctions $S_{ns}(p)$ ou $D_{ns}(p)$ pour numéroter les structures, et donc écrire un identifiant ayant un nombre de segments *ns* fixe, tout en gardant la variation sur la taille de chaque segment. Comme pour la méthode 2, afin de conserver un procédé de codage/décodage bijectif, une règle utilisateur doit être définie, affectant à l'un des segment (le dernier, premier, ou autre) les bits ou octets non nécessaires au codage de l'identifiant.

**Applications Industrielles**

Tout d'abord, commençons par préciser quelques aspects quantitatifs des algorithmes et codages à travers quelques exemples générés à l'aide du programme joint en annexe :

>>> STs(7,14)

9908

```
>>> log(9908,2)

13.274378153246364

>>> TD7(14)

4096

>>> log(4096,2)

12.0

>>> STs(5,14)

3473

>>> log(3473,2)

11.761966695382092

>>> TD5 (14)

1093

>>> log(1093,2)

10.094077685671905

>>> STs(7,7)

128

>>> log(128,2)

7.0

>>> TD7(7)

64

>>> log(64,2)

6.0

>>> STs(5,7)

120

>>> log(120,2)

6.9068905956085187

>>> TD5 (7)

57

>>> log(57,2)
```

5.8328900141647422

>>> Structs(5,14)

715

>>> log(715,2)

9.4817994316657526

>>> Structs(4,15)

364

>>> log(364,2)

8.5077946401986964

>>> Structs(4,14)

286

>>> log(286,2)

8.1598713367783891

>>> Structs(5,7)

15

>>> log(15,2)

3.9068905956085187

>>>

>>> TD7(98)

1056235426

>>> log(1056235426,2)

29.976284289125385

>>> TD5 (46)

164221

>>> log(164221,2)

17.325279100082771

C'est-à-dire, sur 16 octets, les méthodes 1 et 2 permettent de coder un identifiant à 7 segments variables maximum, en réservant 2 octets pour la structure et 14 octets pour l'identifiant. 2 bits sont « gaspillés » avec la méthode 1, et 4 avec la méthode 2 ; bits qui peuvent être affectés à l'identifiant selon des règles ou réservés pour utilisation futures imprévues ou locales.

Pour 5 segments maximum sur 16 octets, cela donne aussi 2 octets de structure avec respectivement 4 et 5 bits gaspillés pour les méthodes 1 et 2.

Sur 8 octets et 7 segments maximum, la structure nécessite 1 octet avec 1 et 2 bits gaspillés respectivement pour les méthodes 1 et 2. Pour 5 segments maximum, 1 octet de structure est également nécessaire avec respectivement 1 et 2 bits gaspillés.

Pour un nombre de segments fixe, 2 octets de structure sont nécessaires sur 16 pour 5 segments avec 6 bits de gaspillés.

Si on prend le bit et non l'octet comme variabilité des segments, 30 bits sont nécessaires sur 128 pour 7 segments maximum avec la méthode 2.

On voit donc que l'espace nécessaire à coder la structure est relativement faible par rapport à l'espace disponible pour l'identifiant lui-même.

Comme il a été dit au début, toute organisation utilisant des identifiants de type $n_1.n_2.....n_j$, pourrait donc mettre à profit ces techniques pour :

1. Simplifier les règles régissant chaque segment (pas de taille prédéfinie) et l'affectation des numéros correspondants. Seules des règles d'exceptions ou d' « overflow » seraient nécessaires dans la distribution, en fonction des formats cibles choisis pour les écritures en taille fixe.

2. Continuer à utiliser une taille fixe pour les identifiants dans tout contexte ou cela s'avère nécessaire ou pratique (bases de données, codes barres, puces RFID, transmission de données, etc ...).

Pour faciliter l'utilisation pratique, une organisation utilisant ces techniques devrait probablement limiter le nombre de formats d'identifiants « empaquetés » utilisés. On peu par exemple imaginer une liste de formats cibles du type :

- TS58 : 5 segments maximum sur 8 octets
- TS716 : 7 segments maximum sur 16 octets
- TS732 : 7 segments maximum sur 32 octets

**ANNEXE**

Le programme en langage de programmation Python qui suit est joint dans un but d'explicitation complète des procédés.

```
# -*- coding:Latin-1 -*-
# Ce programme a pour but d'exprimer entièrement les fonctions et algorithmes décrits
# pour la mise en place des procédés, ainsi que de déterminer le nombre d'octets ou bits
# nécessaires au codage du numéro de structure pour un couple (ms, p) donné.
# L'implémentation des algorithmes peut bien sur être grandement optimisée une fois les
# choix de nombres de segments max et nombres d'octets max faits
 from math import *
from random import *

# Structs est la fonction qui retourne le nombre de structures à i segments sur un
# identifiant à p octets.
# Ou également bien sûr, le nombre de structures à i segments sur un identifiant à p bits.
# note: le nombre de structure à 0 segment sur p octets est 1
def Structs (i,p ) :
    if i==1 or i==0 :
         return 1
    elif i==2:
        return p-1
    elif i==3:
        return ((p-1)*(p-2))//2
    elif i==4:
        return ((p-1)*(p-2)*(p-3))//6
    elif i==5:
        return ((p-1)*(p-2)*(p-3)*(p-4))//24
    elif i==6:
        return ((p-1)*(p-2)*(p-3)*(p-4)*(p-5))//120
    elif i==7:
        return ((p-1)*(p-2)*(p-3)*(p-4)*(p-5)*(p-6))//720
    elif i==8:
```

```
        return ((p-1)*(p-2)*(p-3)*(p-4)*(p-5)*(p-6)*(p-7))//5040
    else:
        print "i is out of range in Structs, value : " , i
# STs est la fonction qui retourne le nombre total de structures à i ou moins segments
# dans p octets,
# y compris la structure vide (ou à 0 segment) qui compte pour une structure.
# cette fonction à réécrire directement en polynomes
def STs (i,p):
    j=1
    r=1
    while j <= i :
        k=j
        while k <= p :
          r += Structs (j,k)
          k+=1
        j+=1
    return r
return r


#tOc retourne la taille minimale en octets pour coder l'entier i
def tOc (i) :
    if (i==0 or i==1) :
        return 1
    else:
        return int(log(i,2))//8+1


# AlgCodage prend en input une liste ls de tailles de segments, et retourne le numéro de
# structure correspondant.
# Ceci pour un nombre de segments max MS et une taille d'octets max P.
# Idstr est l'offset du numéro de structure dans les appels récursifs.
# Le principe est d'incrémenter Idstr avec les structures à taille de premier segment
# inférieur à celle considérée,
# puis appelrécursif sur le deuxième segment une fois positioné dans le bon intervalle.
ls= []
def AlgCodage (ls , MS , P, Idstr=0) :
    l1=len(ls)
    lseg1=0
    pos=0
    i=0
    if l1==0:
    return Idstr
else :
    lseg1=ls [0]
    while i<lseg1:
        if i==0 : Idstr=Idstr+1
        else : Idstr=Idstr+STs(MS-1,P-i)
        i+=1
    del ls [0]
    return AlgCodage(ls,MS-1,P-lseg1,Idstr)


# AlgDecodage prend en input un numéro de structure, et renvoi la liste de tailles de segments
# correspondante.
# Ceci pour un nombre max de segments MS et un nombre max d'octets P
ls= []
def AlgDecodage (Idstr, ls, MS, P):
    lseg1=0 #taille premier segement courant
    pos=0
    if Idstr==0 : return ls
    while True:
        if lseg1==0 : pos=pos+1
        else : pos=pos+STs(MS-1,P-lseg1)
        if Idstr>=pos :
            int1=pos
```

```
            lseg1+=1
        else : break
    ls.append(lseg1)
    return AlgDecodage(idstr-inti,ls,MS-1,P-lseg1)


# CodeListInt prend une liste d'entier en entrée et la transforme en un entier (binaire),
# avec le code de structure au début et ensuite les entiers
# Note : nous avons fixé ici le nombre de segments max à 7 et le nombre d'octets max à 14
# pour les entiers (16 en tout), ie 128 bits,
# la structure est codée sur 16 bits, 13 suffiraient
lint=[]
def CodeListInt (lint):
    ll=len(lint)
    lo=list(lint)
    i=0
    to=0
    while i<11 :
        t-tOc(lint[i])
        lint[i]=t
        to=to+t
        i+=1
    if to>14 :
        print "overflow", to
        return to
    lt=list(lint)
    nstruct=AlgCodage(lint,7,14)
    i=0
    bint=nstruc
    offset=16
    while i<11 :
        bint=bint | lo[i]<<offset
        offset=offset + 8*lt[i]
        i+=1
    return bint


# mmask retourne un masque sur le p octet
def mmask (p):
    ones=255
    return ones<<8* (p-1)


# DecodeListInt prend un entier ou numéro ISCN "empaqueté" et renvoi la liste d'entiers
# correspondante
def DecodeListInt (intg):
    mask=mmask(1) |mmask(2)
    nstruct= intg & mask
    intg=intg>>16
    ls=AlgDecodage(nstruct, [],7, 14)
    ll=len(ls)
    lint= []
    i=0
    off=0
    while i<ll :
        mask=0
        k=0
        while k<ls[i] :
            mask= mask | mmask(k+1)
            k+=1
        lint.append((intg & (mask<<(off*8)))>>off*8)
        off=off+ls[i]
        i+=1
    return lint


#Test de Code et Decode pour ms=7, n tests sont effectués
```

```
def test (n):
    i=1
    lint= []
    lseg=[]
    while i<=n:
        1=randrange(1,8)
        mo=14
        k=1
        while k<=1 :
            tseg=randrange(1,mo-(l-k)
            lseg.append(tseg)
            mo=mo-tseg
            lint.append(randrange(pow(2,tseg*8)))
            k+=1
    i+=1
    olint=list(lint)
    bint=CodeListInt(lint)
    dlint=DecodeListInt(bint)
    if cmp(olint,dlint) !=0:
        printh(olint)
        print lseg
        print hex(bint)
        print hex(bint>>16)
        printh(dlint)
        return False
    lint=[]
    lseg=[]
 return True


#affichage hexadécimal d'une liste pour les tests
def printh (1):
    print "[",
    for n in 1 :
        print hex(n), "," ,
    else : print "] "


#Les fonctions ci dessous implémentent les fonctions Dj(p) et TDj(p)
#de la méthode ou solution 2
def D1(p) :
    return 1

 def D2 (p) :
    if p<2:
        print "D2 error" , p
     else
        return p-1


def D3(p):
    r=0
    if p<3:
      print "D3 error" , p
    else:
      i=1
      while i <= p-2:
            r+=D2(p-i)
            i+=1
      return r


def D4(p):
    r=0
    if p<4:
      print "D4 error" , p
    else :
```

```
        i=1
        while i <= p-3:
            r+=D3(p-i)
            i+=1
        return r

def D5(p) :
    r=0
    if p<5:
        print "D5 error" , p
    else:
        i=1
        while i <= p-4:
            r+=D4(p-i)
            i+=1
        return r

def D6(p):
    r=0
    if p<6:
        print "D6 error" , p
    else:
        i=1
        while i <= p-5:
            r+=D5(p-i)
            i+=1
        return r

def D7(p):
    r=0
    if p<7:
        print "D7 error" , p
    else:
        i=1
        while i <= p-6:
            r+=D6(p-i)
            i+=1
        return r

def TDS(p):
    return D1(p)+D2(p)+D3(p)+D4(p)+D5(p)
def TD7(p):
    return D1(p)+D2(p)+D3(p)+D4(p)+D5(p)+D6(p)+D7(p)
```

## Revendications

1. Procédé d'écriture, de stockage et de lecture de données sur disques durs, enregistrements de base de données, puces RFID, mémoire de type ROM ou RAM, cartes magnétiques ou impressions de type codes à barres **caractérisé en ce que** les données à écrire, stocker et lire, sont constituées de segments alphanumériques en taille et nombre variables, mais l'écriture est elle de taille fixe sans contrainte sur la taille individuelle de chaque segment et le nombre de ces segments, la seule contrainte portant sur la somme des tailles des segments et un nombre de segment maximal, l'écriture étant constituée d'une part d'un numéro de structure et des segments concaténés, ceci à travers l'utilisation d'un algorithmes de codage utilisant une numérotation de toutes les structures possibles en tailles et nombre de segments, la lecture utilisant elle le numéro de structure pour déterminer tous les segments, en utilisant un algorithme de décodage à partir du numéro de structure.

2. Procédé d'écriture, de stockage et de lecture de données sur disques durs, enregistrements de base de données, puces RFID, mémoire de type ROM ou RAM, cartes magnétiques ou impressions de type codes à barres selon la revendication 1 **caractérisé en ce que** les segments à écrire sont en nombre et tailles variables, et que toutes les structures possibles sont considérées et numérotées, y compris celles ne remplissant pas tout l'espace d'écriture.

3. Procédé d'écriture, de stockage et de lecture de données sur disques durs, enregistrements de base de données, puces RFID, mémoire de type ROM ou RAM, cartes magnétiques ou impressions de type codes à barres selon la revendication 1, **caractérisé en ce que** les segments à écrire sont en nombre et tailles variables, et que seules les structures remplissant tout l'espace d'écriture sont considérées et numérotées, ceci étant associé à une règle définie par l'utilisateur pour conserver des processus de codage et décodage dont la composition soit égale à l'identité.

4. Procédé d'écriture, de stockage et de lecture de données sur disques durs, enregistrements de base de données, puces RFID, mémoire de type ROM ou RAM, cartes magnétiques ou impressions de type codes à barres selon la revendication 1, **caractérisé en ce que** les segments à écrire sont en nombre fixe et tailles variables, et que seules les structures remplissant tout l'espace d'écriture sont considérées et numérotées, ceci étant associé à une règle définie par l'utilisateur pour conserver des processus de codage et décodage dont la composition soit égale à l'identité.

Europäisches
Patentamt

European
Patent Office

Office européen
des brevets

# RAPPORT DE RECHERCHE EUROPEENNE

Numéro de la demande

EP 08 29 0673

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | ANONYMOUS: "4. Structure of ISBN" INTERNET CITATION, [Online] XP002458229 Extrait de l'Internet: URL:http://www.isbn.org/standards/home/isbn/international/html/usm4.htm> [extrait le 2007-11-07] * le document en entier * | 1-4 | INV. H03M7/30 |
| A | ANONYMOUS: "Basics and Principles of the GS1 System" INTERNET CITATION, [Online] XP002458228 Extrait de l'Internet: URL:http://www.gs1uk.org/eanucc/word_files/gs_section_1_v7.doc> [extrait le 2007-11-07] * le document en entier * | 1-4 | |
| A | ANONYMOUS: "Combinatorics" INTERNET CITATION, [Online] XP002458227 Extrait de l'Internet: URL:http://en.wikipedia.org/w/index.php?title=Combinatorics&oldid=101616117> [extrait le 2007-11-07] * le document en entier * | 1-4 | DOMAINES TECHNIQUES RECHERCHES (IPC) H03M |
| A | ANONYMOUS: "Bit stuffing" INTERNET CITATION, [Online] XP002458226 Extrait de l'Internet: URL:http://en.wikipedia.org/w/index.php?title=Bit_stuffing&oldid=102204594> [extrait le 2007-11-07] * le document en entier * | 1-4 | |

Le présent rapport a été établi pour toutes les revendications

| Lieu de la recherche | Date d'achèvement de la recherche | Examinateur |
|---|---|---|
| La Haye | 18 décembre 2008 | Rydyger, Kay |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)